(19) Europäisches Patentamt

European Patent Office

Office européen des brevets

(11) **EP 1 705 684 A1**

(12) **EUROPEAN PATENT APPLICATION**

(43) Date of publication:
27.09.2006 Bulletin 2006/39

(51) Int Cl.:
*H01J 19/12* (2006.01)　　*H01J 37/07* (2006.01)
*H01J 37/24* (2006.01)　　*H01J 1/13* (2006.01)
*H01J 1/16* (2006.01)　　*H01J 3/02* (2006.01)

(21) Application number: 05006277.7

(22) Date of filing: 22.03.2005

(84) Designated Contracting States:
AT BE BG CH CY CZ DE DK EE ES FI FR GB GR
HU IE IS IT LI LT LU MC NL PL PT RO SE SI SK TR
Designated Extension States:
AL BA HR LV MK YU

(71) Applicant: ICT Integrated Circuit Testing
Gesellschaft für Halbleiterprüftechnik mbH
85551 Heimstetten (DE)

(72) Inventors:
• **Adamec, Pavel**
85540 Haar (DE)
• **Lanio, Stefan**
85435 Erding (DE)

(74) Representative: **Zimmermann & Partner**
Postfach 33 09 20
80069 München (DE)

(54) **Stabilized emitter and method for stabilizing same**

(57)　An emitter for a charged particle beam apparatus is provided, said emitter comprising a filament (3) extending between and being attached to first and second supports (2), an emitter tip (4) attached to the filament (3), and a stabilization element (6) attached to a third support (5) and to the filament (3), wherein the first, second and third supports (2, 5) define a triangle so that the stabilization element (6) extends at least partially in a direction perpendicular to the direction in which the filament (3) extends.

Fig. 1a

## Description

## FIELD OF THE INVENTION

The invention relates to an emitter for a charged particle beam apparatus as it is specified in the preamble of claim 1 as well as to a method for stabilizing the temperature of such an emitter.

## BACKGROUND OF THE INVENTION

Technologies like microelectronics, micromechanics and biotechnology have created a high demand in industry for structuring and probing specimens within the nanometer scale. On such a small scale, probing or structuring, e.g. of photomasks, is often done with electron beams which are generated and focussed in electron beam devices like electron microscopes or electron beam pattern generators. Electrons beams offer superior spatial resolution compared to e.g. photon beams due to their short wave lengths at a comparable particle energy.

Although the prior art and the present invention will be described in the following with reference to electrons, electron beams, electron emitters, or electron microscopes, it should be understood that the explanations are also true for other charged particles, like ions, ion beams, ion emitters etc.

The first step in the process of creating images in any electron microscope is the production of an electron beam. The electron beam is generated in a device often called an electron gun. Three major types of electron guns are used in electron microscopes: tungsten-hairpin filament guns, lanthanum-hexaboride guns, and field-emission guns. Field-emission guns offer several advantages over tungsten-hairpin filament guns or lanthanum-hexaboride guns: First, the brightness may be up to a thousand times greater than that of a tungsten gun. Second, the electrons are emitted from a point more narrow than that in the other sources. Thus, superior resolution is achieved by field-emission guns compared to tungsten or $LaB_6$ guns. Furthermore, the energy spread of the emitted electrons is only about one-tenth that of the tunsten-hairpin gun and one-fifth that of the $LaB_6$ gun. Finally, the field-emission gun has a very long life, up to a hundered times that of a tungsten gun. For these reasons, the field-emission gun is the preferred choice for a number of applications.

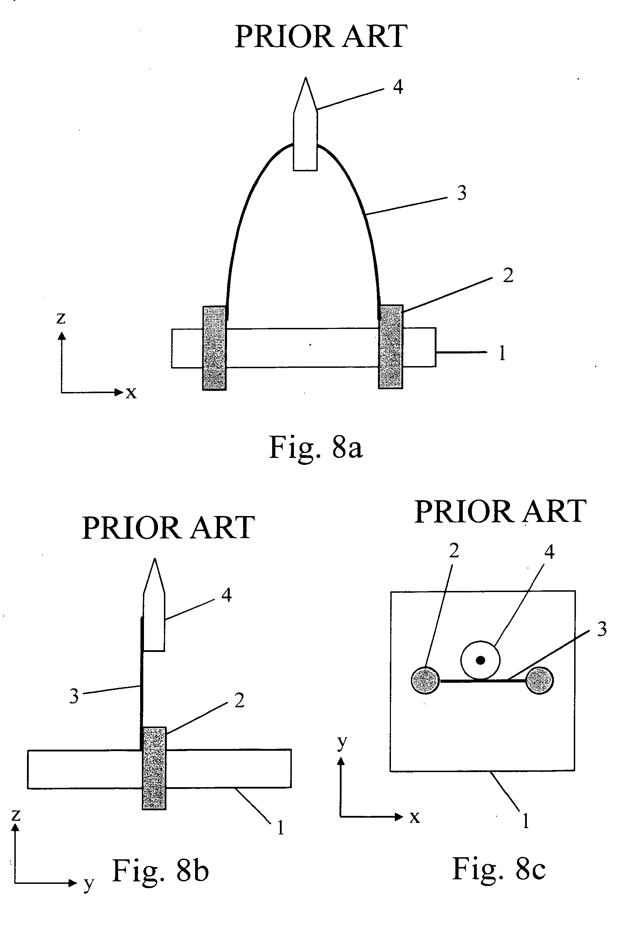

The typical construction of a conventional electron emitter, like e.g. a thermal field-emission (TFE) gun, a cold field-emission (CFE) gun, or a field-assisted photocathode, is shown in Figs. 8a to 8c. In Fig. 8a, the emitter assembly is mounted on an insulating ceramic base 1. A loop of tungsten wire 3 is attached to two metal support pins 2. Typically, the bent tungsten wire 3 is attached to support pins 2 by spot welding. A very finely curved sharp tungsten tip serves as the emitter tip 4 and is attached to the bent tungsten wire 3. Typically, the emitter tip 4 is attached to the heating filament 3 by spot welding.

During operation, the bent tungsten wire 3 is resistively heated by an electric current flowing through it. As a result, also the temperature of the emitter tip 4 is raised to a desired value. Thus, tungsten wire 3 acts as a heating filament.

However, the conventional field-emission gun shown in Figs. 8a to 8c suffers from two limitations: mechanical vibration of the emitting tip and insufficient control of the tip temperature.

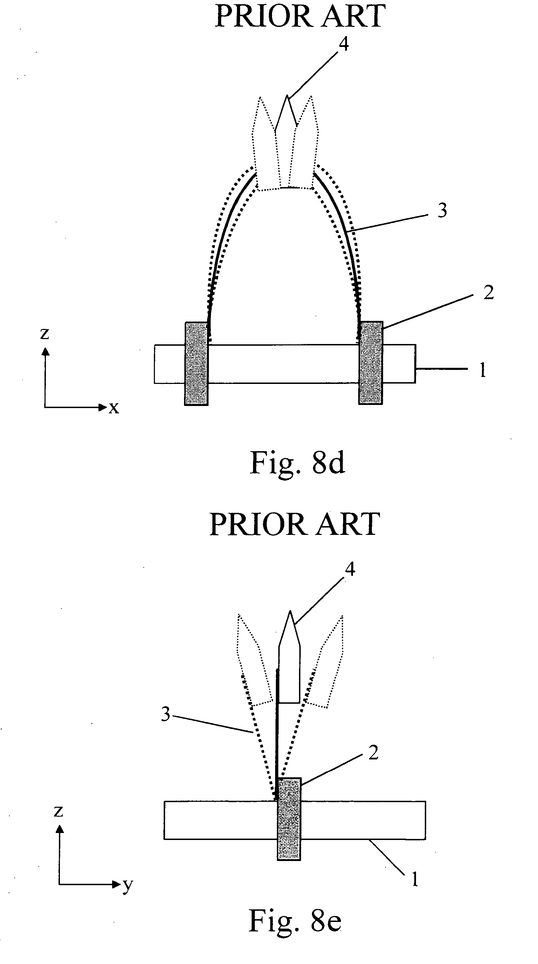

First, the problem of mechanical vibration will be explained with reference to Figs. 8d and 8e. Fig. 8d shows a first vibrational mode of the conventional field-emission gun shown in Figs. 8a to 8c. In this first vibrational mode, the emitter tip 4 undergoes a displacement in the x-direction. However, the emitter configuration is stiff in the x-direction so that such a displacement in x-direction corresponds to a higher order vibrational excitation which may even include torsion movements of the heating filament 3. Accordingly, such a high order vibrational mode has a very high eigenfrequency and is strongly damped. Therefore, this first vibrational mode has only a very small amplitude and, therefore, has not yet been observed in experiments.

Fig. 8e shows a second vibrational mode of the conventional field-emission gun shown in Figs. 8a to 8c. In this second vibrational mode, the emitter tip 4 undergoes a displacement in the y-direction. This displacement in the y-direction is caused by bending of the heating filament 3. While being stiff in the x-direction, the emitter configuration is not very stiff in the y-direction so that a bending movement of the heating filament 3 in the y-direction corresponds to a low order vibrational mode. Typically, this second vibrational mode of the emitter has an eigenfrequency of about 2 kHz. Furthermore, the damping is not very strong so that the second vibrational mode has a considerable amplitude. In fact, this amplitude may be so large, e.g. within the nanometer range, that it can be observed in an experiment. Consequently, the displacement of the emitter tip 4 in the y-direction limits the resolution of some electron microscopes.

Besides mechanical stability, also thermal stability of the emitter tip 4 is an important aspect for thermal field-emission guns. The beam current generated by the gun depends not only on the extraction voltage but also on the temperature of the emitter tip 4. Variations in tip temperature lead to variations in beam current which may deteriorate the results in electron beam applications. Particularly, in the working range of the emitter the temperature dependency of the beam current is $I_{beam} \sim \exp(-W/kT)$, wherein W is the work function. Therefore, even small variations in the temperature of the emitter tip result in large variations of the beam current. However, electron beam lithography and inspection are especially beam current sensitive applications which require long term emission stability for obtaining sufficient results. For example, mask patterning by electron beam lithography takes about 12 hours per mask, wherein the emission characteristic of the electron source must not change during this time. Therefore, temperature stability of charged particle sources are a strong requirement for such applications. Consequently, the temperature of the emitter tip is sensed by a pyrometer in some conventional charged particle beam apparatus. However, such a solution is expensive and not feasible, especially in fully automated inspection tools.

It is therefore an object of the present invention to overcome at least in part the disadvantages associated with the prior art as they have been explained above.

## SUMMARY OF THE INVENTION

This object is solved by an emitter according to claim 1 and a method according to claims 20 and 23.

Further advantages, features, aspects and details of the invention are evident from the dependent claims, the description and the accompanying drawings.

According to a first aspect of the present invention, an emitter for a charged particle beam apparatus, preferably for an electron microscope, is provided which comprises a filament, typically made of a loop of tungsten or iridium wire of 0.1 mm diameter, which is fixed to first and second supports so that the filament extends from one support to the other. An emitter tip is attached to the filament, typically by spot welding, wherein the emitter tip is typically made of a tungsten crystal formed to a very narrow point. Furthermore, a stabilization element extends between a third support and the filament, and is attached to both the third support and the filament. The first, second and third supports define a triangle. Consequently, the stabilization element extends at least partially in a direction perpendicular to the direction in which the filament extends.

Since the supports of the filament and the stabilization element define a non-degenerate triangle, the stabilization element will at least partially extend perpendicular to the filament. In other words, if the filament extends in the x-direction, the stabilization element will extend in the y-direction. Thereby, an extension of the filament and the stabilization element in the z-direction can be disregarded. As a result, the stabilization element enhances the stiffness of the emitter configuration. When the second vibrational mode of the emitter configuration (see Fig. 8e) is excited, the stabilization element substantially prevents the displacement of the emitter tip in the y-direction. Thus, the resolution of a charged particle beam apparatus using the emitter according to this aspect of the present invention is improved.

Simultaneously, the emitter having the above described configuration is adapted for temperature stabilization according to a method which forms a different aspect of the present invention. This method will be described further below. The thus configured emitter provides therefore not only improved resolution due to its mechanical stability but can also provide improved thermal stability. As a result, the emission characteristics of such an emitter can be maintained stable over a long time, thus rendering the emitter advantageous for beam current sensitive applications like electron beam lithography or inspection.

According to an embodiment of the present invention, the stabilization element is a stabilization wire and, typically, a tungsten wire. Thus, the stabilization element can be manufactured from the same material as the filament and the attachement techniques for the filament can be also used for the stabilization element. Also, the stabilization element according to this embodiment is electrically conducting which may be desired for some applications.

According to another embodiment of the present invention, the stabilization element is attached to the filament at a point close to the emitter tip. When attached to the filament at this position, the stabilization element can especially effective suppress the vibrational motion of the emitter tip. However, it should be understood that the stabilization element may also be attached to the filament at a point farther away from the emitter tip if this is useful, e.g., if the stabilization element leads off to much heat from an apex region of the filament where the emitter tip is located.

According to still another embodiment of the present invention, the stabilization element may be spot-welded to the filament, thus providing a rigid and stiff connection. However, according to another embodiment of the present invention the stabilization element may simply abut against the filament in a resilient manner. In this embodiment, no rigid connection, e.g. by spot welding, between the filament and the stabilization element is necessary since the spring forces inherent to the stabilization element provide sufficient restoring forces to suspend the unwanted mechanical oscillations. Alternatively, in another embodiment of the present invention the stabilization element is integrally formed with the emitter tip. Since the emitter tip is typically formed from tungsten wire, it is possible to use the distal end of the wire as the stabilization element.

According to a further embodiment of the present invention, the support to which the stabilization element is attached is a metal pin. Typically, this pin is supported by and extending through an insulating base usually made of ceramic. Typically, the metal pin is brazed to the ceramic base. Thus, the stabilization element can be connected to measurement devices, e.g. voltmeters or amperemeters, to provide information about the emitter configuration. Where such measurement is not needed, the support of the stabilization element may be simply attached to a surface of the ceramic base. Typically, it can be formed as a metal cylinder brazed to the surface of the ceramic base.

According to still another embodiment of the present invention, there may be provided at least one further stabilization element. Like the first stabilization element, this further stabilization element is attached to a support and to the filament, and extends also perpendicular to the filament. Such further stabilization elements will further improve the mechanical strength of the emitter configuration so that vibrational motions are strongly damped, and, as a result, the resolution is further enhanced.

According to another embodiment of the present invention, at least two stabilization elements are attached to the filament at opposite sides of the emitter tip. Thus, the vibration of both branches of the filament can be effectively damped. Furthermore, this configuration allows for currentless voltage measurement between the two attachment points of the stabilization elements. Also, a four-point measurement of the electrical resistance of can be accomplished in this embodiment. From the measured resistance, the temperature of the emitter tip can be inferred. Typically, the distance between the attachment point of the first stabilization element and the emitter tip is substantially equal to the distance between the attachment point of the further stabilization element and the emitter tip so that the emitter configuration is symmetric. Typically, the supports of the first and second stabilization elements are located on opposite sides of the filament which enhances the stiffness of the emitter configuration even more.

According to another aspect of the present invention, a method for thermally stabilizing an emitter is provided. This method comprising the steps of determining a first voltage between the first support and the attachment point of the stabilizing element to the filament, determining a second voltage between the second support and the attachment point of the stabilizing element to the filament, determining a current through the filament, determining the temperature of the emitter tip from the first and second voltages and the current, and controlling a current source connected to the first and second supports so that the temperature of said emitter tip is maintained within a predetermined range. Typically, the method according to this aspect of the invention is realized with an emitter according to the aforementioned aspect of the present invention.

Due to the above described method aspect of the present invention, the temperature of the emitter tip can be determined by a simple voltage and current measurement. The measuring devices therefor can be placed outside the vacuum which gives considerable flexibility. Compared to temperature control via a pyrometer, the present temperature control method is less expensive and of reduced design complexity.

Typically, the temperature is determined from the resistance of the filament or from the power supplied to said filament.

According to another embodiment of the present invention, a temperature control method with the following steps is provided: measuring a voltage between a first attachment point of the first stabilizing element to the filament and a second attachment point of the further stabilizing element to the filament, determining a current through the filament, determining the temperature of the emitter tip from the voltage and the current, and controlling a current source connected to the first and second supports so that the temperature of said emitter tip is maintained within a predetermined range.

Due to the above described method, the temperature of the emitter tip can be determined by a simple voltage and current measurement. Thus, the same advantages as in the aforementioned method can be achieved. Furthermore, the method according to the present embodiment allows to directly detect the voltage across the apex region of the filament.

**BRIEF DESCRIPTION OF THE DRAWINGS**

Some of the above indicated and other more detailed aspects of the invention, will be described in the following description and partially illustrated with reference to the figures. Therein:

| | |
|---|---|
| Fig. 1a | shows a front view of an embodiment of the present invention. |
| Fig. 1b | shows a side view of the embodiment shown in Fig. 1a. |
| Fig. 1c | shows a plan top view of the embodiment shown in Fig. 1a. |
| Fig. 2a | shows a front view of an embodiment of the present invention. |
| Fig. 2b | shows a side view of the embodiment shown in Fig. 2a. |
| Fig. 2c | shows a plan top view of the embodiment shown in Fig. 2a. |
| Fig. 3a | shows a front view of another embodiment of the present invention. |
| Fig. 3b | shows a side view of the embodiment shown in Fig. 3a. |
| Fig. 3c | shows a plan top view of the embodiment shown in Fig. 3a. |
| Figs. 4a to 4d | show plan top views of further embodiments of the present invention. |
| Figs. 5a and 5b | show a diagram explaining a measurement principle. |
| Fig. 6a | shows a top view of an embodiment of the present invention which is adapted for temperature stabilization. |
| Fig. 6b | is a schematic representation of the embodiment shown in Fig. 6a. |

Fig. 7a          shows a top view of an embodiment of the present invention which is adapted for temperature stabilization.

Fig. 7b          is a schematic representation of the embodiment shown in Fig. 7a.

Fig. 8a          shows a front view of an emitter according to the prior art.

Fig. 8b          shows a side view of the prior art emitter shown in Fig. 8a.

Fig. 8c          shows a plan top view of the prior art emitter shown in Fig. 8a.

Fig. 8d          shows a first vibrational mode of the prior art emitter shown in Fig. 8a.

Fig. 8e          shows a second vibrational mode of the prior art emitter shown in Fig. 8a.

## DETAILED DESCRIPTION OF THE DRAWINGS

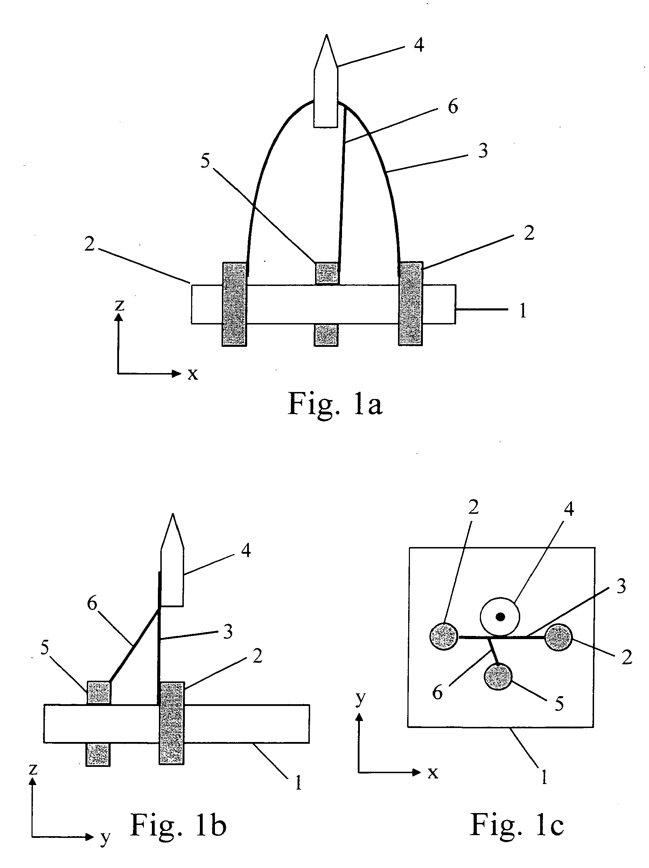

Fig. 1a shows a front view of an embodiment of the present invention. Therein, an emitter configuration for an electron beam apparatus is mounted to a ceramic base 1. The emitter configuration comprises a filament 3 made of tungsten wire. To form the filament 3, the tungsten wire is bent into a loop and the free ends of the loop are attached to first and second support pins 2 by spot welding. The support pins 2 are made of metal and extend through the ceramic base 1 so that electrical contact can be made to the filament 3 via the support pins 2. The support pins 2 are supported by the ceramic base to which they are brazed. An emitter tip 4 is attached to the filament 3 by spot welding. The emitter tip 4 is comprised of a tungsten crystal which has been formed into a very sharp tip, e.g., by etching. Typically, the emitter tip 4 is spot welded to the filament 3. A third support pin 5 is provided. Like the first and second support pins 2, also the third support pin 5 is made of metal and extends through the ceramic base 1. A stabilization element 6 is attached to the third support pin 5 and on the right-hand side of the filament 3 adjacent to the emitter tip 4. Typically, this stabilization element 6 is formed of a tungsten wire like the filament 3 and spot welded to the third support pin 5 and the filament 3. However, the stabilization element 6 may not be spot-welded to filament 3 but simply abut against the filament 3 in a resilient manner. Thus, the mechanical vibrations of filament 3 are prevented due to the spring forces of stabilization element 6 acting on filament 3. Alternatively, the stabilization element 6 is integrally formed with the emitter tip 4. Since the emitter tip 4 is typically formed from tungsten wire, it is possible to use the distal end of the wire as the stabilization element.

Fig. 1b shows a side view of the embodiment shown in Fig. 1a. Therefrom, it is apparent that the third support pin 5 is displaced from the first and second support pins 2 in the y-direction. Therefore, the stabilization wire 6 extends not only in the z-direction but also in the y-direction. This can also be seen from Fig. 1c showing a plan top view of the present embodiment. Therein, it is apparent that the first, second, and third support pins 2, 5 form the corners of a triangle, i.e. they define a triangle. Since the stabilization wire 6 connects one of the angles of the triangle with the opposing side of the triangle, it must extend in a direction perpendicular to this side. In the present embodiment, the x-direction was chosen as the direction in which the filament 3 extends. Consequently, the stabilization wire 6 extends in the y-direction. Since the y-direction is the direction in which the displacement of the emitter tip 4 occurs when the second vibrational mode is excited (see Fig. 8e), the stabilization wire 6 enhances the rigidity or mechanical strength of the emitter configuration in this direction. Particularly, when the filament/emitter unit would start to vibrate, mechanical loads due to pushing and pulling forces as well as bending moments are applied to the stabilization wire 6. For this purpose, stabilization wire 6 is designed to absorb the mechanical loads occuring in the emitter configuration. Thereby, the fatigue strength of the stabilization wire 6 and the spot welded connections may be designed either for finite or infinite time. As a result, stabilization element 6 substantially prevents the displacement of the emitter tip 4 in the y-direction so that the resolution of an electron beam apparatus using the emitter according to this embodiment of is improved. In other words, due to the enhanced mechanical stiffness of the electron emitter according to the present embodiment the amplitude of the vibrational motion of the emitter tip is considerably damped.

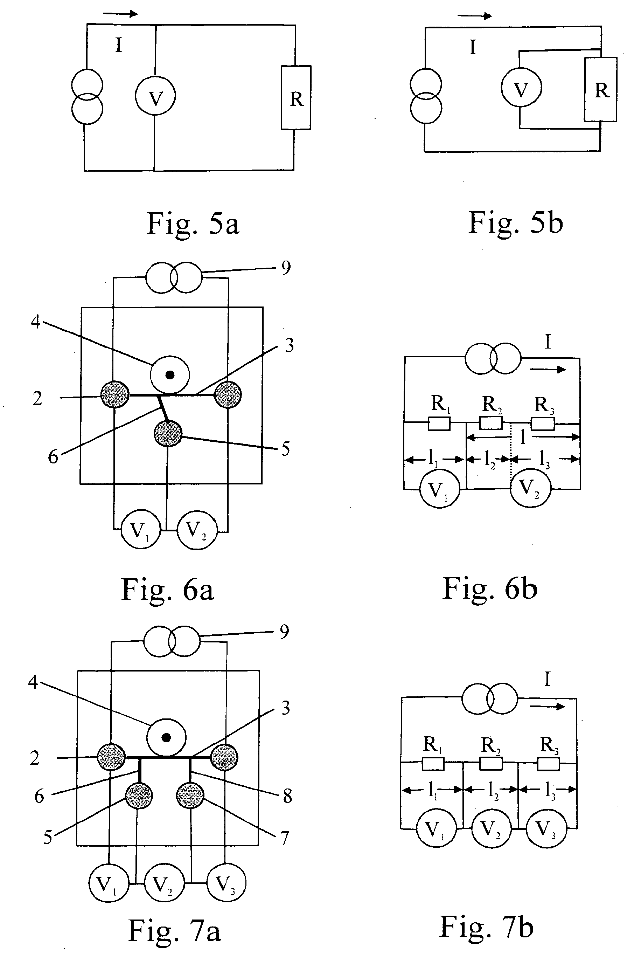

Now, it will be described how the temperature of the emitter tip 4 can be stabilized in the emitter shown in Figs. 1a to 1c. Therefore, preliminary remarks regarding the measurement principle will be made with reference to Figs. 5a and 5b.

In Fig. 5a, a current source providing a current I is connected to a resistor having resistance R. According to Ohm's Law, the voltage drop V across the resistor is V = R x 1. This voltage drop is measured by a voltmeter connected between the lines connecting the current source to the resistor. Since the internal resistance of the voltmeter can be considered as infinite for the present application, no current will flow through the voltmeter. However, the above consideration implicitly assumes that the resistivity of the lines is negligible. Fig. 5b shows the measuring arrangement for the case where the resistivity of the lines is not negligible. In this case, it is important that the measurement points are located adjacent to the resistor so that only a very small amount, preferably a negligible amount, of the lines influences the measurement. Typically, the resistivity of the emitter filament is not negligible, especially for hot cathode emitters.

Fig. 6a is a top view of an embodiment of the present invention which corresponds to the embodiment shown in Fig. 1. Particularly, the emitter of Fig. 6a comprises first and second support pins 2, a filament 3 extending therebetween, an emitter tip 4 attached to the filament 3, and a stabilization wire 6 extending between the filament 3 and a third support pin 5. The first and second support pins 2 are connected with a current source 9 for providing a current I to the filament 3. The current source 9 is controllable, i.e. current I can be adjusted to a desired value. Furthermore, the first, second and third support pins are connected to voltage measurement means so that the voltage drop $V_1$ between the first support pin 2 and the attachment point of the stabilization wire 6 can be determined. Likewise, it is also possible to determine the voltage drop $V_2$ between the second support pin and the attachment point of the stabilization wire 6. The voltage measurement means can be realized by a single voltmeter with several inputs or by individual voltmeters for each voltage to be measured.

Fig. 6b shows an equivalent network for the emitter of Fig. 6a. Therein, a first portion of the filament extending from the first support pin to the attachment point of the stabilization wire has length $l_1$. The resistance of this portion of the filament is represented by a resistor having resistance $R_1$. The voltage drop across resistor $R_1$ is $V_1 = R_1 \times I$. A second portion of the filament extending from attachment point of the stabilization wire to the second support pin has length 1 and resistance R and a voltage drop $V_2$ across its length 1. However, the length 1 can be theoretically divided into two subportions having lengths $l_2$ and $l_3$, thus correspondig to series-connected resistors $R_2$ and $R_3$. Therein, length $l_3$ is chosen to be equal to length $l_1$, $l_3 = l_1$. Assuming now that the differences in the filament structure or the connections to the support pins are negligible for portions $l_1$ and $l_3$, it follows that $R_1 = R_3$. Consequently, also the voltage drop across $R_3$ is equal to $V_1$. Therefore, it follows that $V_2 = (R_2 + R_3) \times I = (R_2 + R_1) \times I$. By subtracting $V_1$ from $V_2$, one obtains the voltage drop across the apex portion of the filament having length $l_2$:

$$V_2 - V_1 = (R_2 + R_1) \times I - R_1 \times I$$
$$= R_2 \times I$$

Now, there are different ways of obtaining the temperature of the emitter tip from the voltage drop across the apex region. For filament materials having a defined temperature dependency of the resistivity, the resistance $R_2$ of the filament portion of length $l_2$ will vary accordingly with temperature, i.e. $R_2$ is a function of the temperature $R_2(T)$. For known values of current I, the temperature T of the filament portion $l_2$ can be thus obtained from the voltage drop across the apex region. Another way of obtaining the temperature is to calculate the power consumed in the apex region, $P = (V_2 - V_1) \times I$. Typically, a the filament temperature is a defined function of the electric power consumed therein, $P = P(T)$. For known values of current I, the temperature T of the filament portion $l_2$ can be thus obtained from the voltage drop across the apex region.

It should be understood that the aforementioned methods obtain the temperature of the filament 3 and not directly that of the emitter tip 4. However, it can be assumed that the emitter tip and the filament are in thermodynamical equilibrium and, therefore, have the same temperature, $T_{tip} = T_{filament}$. Furthermore, it should be understood that, for the purpose of temperature control, it is important to obtain the temperature of the apex region of the filament. Since the temperature varies across the length of the filament, only the temperature of the apex region is a good indicator for the temperature of the emitter tip. Particularly, heat is lead off at the support pins 2 so that the lower portions of the filament are cooled. Therefore, it should be understood that the apex region $l_2$ should be relatively small to give good results for the temperature measurement, i.e. the attachment point of the stabilization wire should be close to the emitter tip. However, it must be observed that heat transfer may occur via the stabilization wire so that heat is lead off from the apex region of the filament. This heat is lost for heating the emitter tip so that the amount of lead-off heat should be kept as small as possible. Therefore, a compromise must be found between placing the attachment point as close as possible to the emitter tip for mechanical and measurement reasons and placing the attachment point far away from the emitter tip for reduced heat transfer. The loss due to heat transfer may also be counterbalanced by increased heating of the filament.

Finally, it is determined whether the temperature of the emitter tip is within a desired range. If this is not the case or if a temperature drift towards the upper or lower boundary of the temperature range is detected, the controllable current source 9 is controlled so that the temperature is raised or lowered. Thus, the temperature of the emitter tip can be kept within a predetermined temperature range. As a result, the emission characteristics of the emitter can be stably maintained for long durations so that such a thermally stabilized emitter is advantageous for beam current sensitve applications.

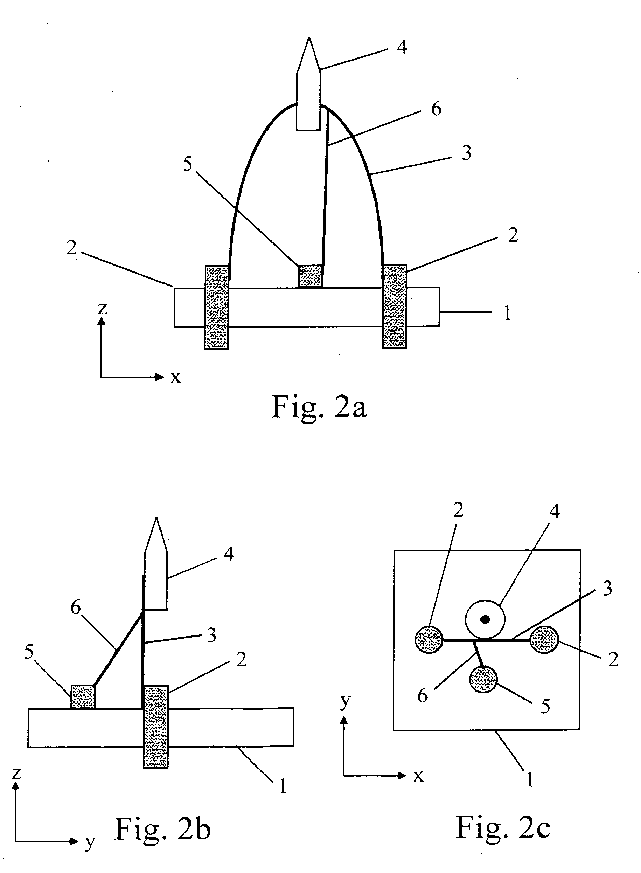

Figs. 2a, 2b and 2c show a further embodiment of the present invention. The basic design is the same as for the embodiment shown in Figs. 1a to 1c. However, in some applications only improved mechanical strength may be an issue but temperature control is not required, e.g. when a cold field-emission cathode gun is used. In this case, it is not necessary to make electrical connection to stabilization element 6 from the backside of the ceramic base 1. Therefore, the third support 5 is not required to extend through the ceramic base 1 but may be formed by a metal cylinder brazed to the top surface of ceramic base 1. Thus, a likewise enhanced mechanical stiffness of the emitter configuration can be achieved. Furthermore, existing emitter configurations can be easily reequipped with a stabilization element according to the present embodiment.

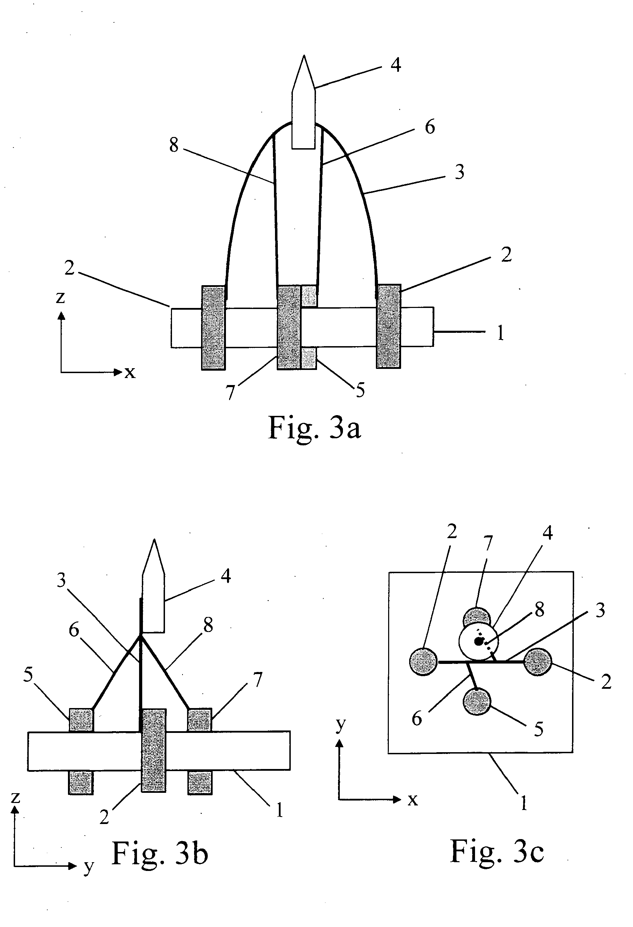

A further embodiment of the present invention is shown in Figs. 3a to 3c. Therein, the basic design is similar to the embodiment shown in Fig. 1. However, a fourth support pin 7 and a second stabilization wire 8 are provided. The fourth support pin 7 is located on the opposite side of the third support pin 5 with respect to the filament 3. Furthermore, the attachment point of the second stabilization wire 8 to the filament 3 is on the opposite side of attachment point of the third stabilization wire 6 with respect to the emitter tip 4. Thus, the stiffness and mechanical strength of the emitter configuration is even more enhanced so that vibrational motion of the filament 3 is effectively reduced or suppressed. Accordingly, the resolution of an emitter according to the present embodiment is improved. If temperature control is not required, the third and fourth supports 5, 7 may be formed by a metal cylinder brazed to the top surface of ceramic base 1 as described above with reference to Figs. 2a to 2c. Thus, a likewise enhanced mechanical stiffness of the emitter configuration can be achieved. Furthermore, existing emitter configurations can be easily reequipped with a stabilization element according to the present embodiment.

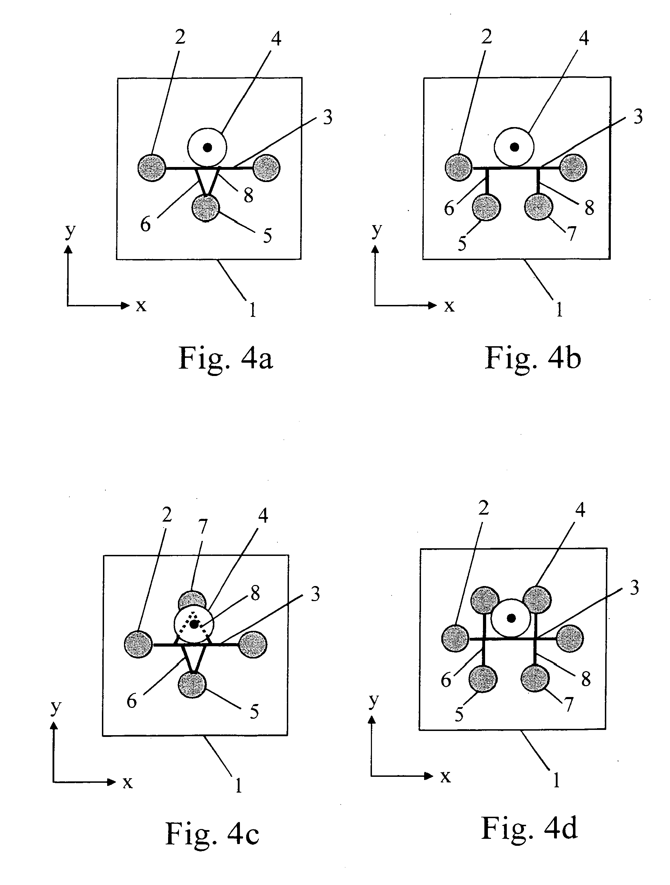

Figs. 4a to 4d show top views of different embodiments of the present invention. All these embodiments comprise more than one stabilization element for enhanced mechanical stiffness of the emitter configuration.

In the embodiment shown in Fig. 4a, a first stabilization element 6 is attached to a third support 5 and the filament 3. A further stabilization element 8 is attached to filament 3 and also to support 5. The attachment points of the first and second stabilization elements 6, 8 are on opposite sides of the emitter tip 4. Thus, the mechanical stiffness of the emitter configuration is enhanced compared to the embodiments shown in Figs. 1 and 2 without the need of an additional support like in the embodiment shown in Fig. 3. However, this configuration may bear the danger of drawing current from the filament, thus briding the apex portion of the filament, or even shorting the apex region so that the heating of the emitter tip is deteriorated. Therefore, care has to be taken when applying the emitter configuration according to the present embodiment.

The embodiment shown in Fig. 4b is similar to the embodiment shown in Figs. 3a to 3c except that the fourth support 7 is located on the same side of filament 3 as the third support 5. This may be advantageous if there is not much space for the second stabilization element 8 to pass emitter tip 4 on the opposite side of filament 3.

The embodiment shown in Fig. 4c is similar to the embodiment of Fig. 4a but contains a fourth support 7 on the opposite side of filament 3. Likewise, the embodiment shown in Fig. 4d is similar to the embodiment of Fig. 4b but contains a further supports on the opposite side of filament 3. Due to the further supports on the opposite side of filament 3, the embodiments in Figs. 4c and 4d are even more rigid and stiff than the embodiments in Figs. 4a and 4b.

It should be understood that the various embodiments described above are only exemplary and that the present invention is not limited to only the aforementioned embodiments. Particularly, a person skilled in the art may combine any number of supports and stabilization elements connected thereto on either side of the filament when desirable for a specific application.

Next, a temperature stabilization method is described with reference to Figs. 7a and 7b, the method being applicable to embodiments having at least two stabilization elements connected to two different supports. For example, such embodiments are shown in Figs. 3a to 3c and 4b to 4d. In these embodiments, it is possible to directly measure the voltage drop $V_2$ across the apex region of the filament 3 without need of any assumptions regarding the properties of the filament and the spot-welded connections to the support pins. Therefore, the voltage drop $V_2$ is directly related to the resistance of the apex portion $l_2$ of the filament. From this directly measured voltage value, the temperature of the filament in the apex region and, correspondingly, the temperature of the emitter tip can be determined by any known method, especially by any of the methods described above with respect to Fig. 6b. Particularly, the temperature may be determined either from a heat-dependent resistivity of the filament or the power consumption in the apex region of the filament. Further to the voltage drop $V_2$ across the apex region of the filament, also the voltage drops $V_1$ and $V_3$ across the filament from the attachment points of the first and second stabilization elements 6, 8 to the first and second supports 2, 2, respectively, can be determined. From the values of $V_1$ and $V_3$, the temperature of filament portions $l_1$ and $l_3$ can be determined. These temperature values are an indication how strongly the filament is cooled by the first and second supports 2, 2. Furthermore, the values $V_1$ and $V_3$ provide information about inhomogeneities of the filament portions $l_1$ and $l_3$ or the spot-welded connections of these portions. Also, it may be detected from these data that the heating filament is deteriorating and preventive maintenance can be triggered.

Finally, it is determined whether the temperature of the emitter tip is within a desired range. If this is not the case or if a temperature drift towards the upper or lower boundary of the temperature range is detected, the controllable current source 9 is controlled so that the temperature is raised or lowered. Thus, the temperature of the emitter tip can be kept within a predetermined temperature range. As a result, the emission characteristics of the emitter can be stably maintained for long durations so that such a thermally stabilized emitter is advantageous for beam current sensitve applications.

It should be understood from the above description of the present invention that the emitter configuration according to the embodiments of the present invention simultaneously provides improved resolution due to enhanced mechanical stiffness as well as improved emission stability due to thermal stabilization. Thus, two important aspects of the emitter design process can be improved by a single modification of the prior art emitters.

**Claims**

1. An emitter for a charged particle beam apparatus, comprising
a filament (3) extending between and being attached to first and second supports (2),
an emitter tip (4) attached to the filament (3), and
a stabilization element (6) attached to a third support (5) and to the filament (3), wherein the first, second and third supports (2, 5) define a triangle so that the stabilization element (6) extends at least partially in a direction perpendicular to the direction in which the filament (3) extends.

2. The emitter according to claim 1, wherein said stabilization element (6) is a stabilization wire.

3. The emitter according to claim 2, wherein said stabilization wire is a tungsten wire.

4. The emitter according to any of the preceding claims, wherein said stabilization element (6) is attached to said filament (3) at a point adjacent to said emitter tip (4).

5. The emitter according to any of the preceding claims, wherein said stabilization element (6) is attached to said filament (3) by spot welding.

6. The emitter according to any of claims 1 to 4, wherein said stabilization element (6) abuts resiliently against said filament (3).

7. The emitter according to any of claims 1 to 4, wherein said stabilization element (6) and said emitter tip (4) are integrally formed.

8. The emitter according to any of the preceding claims, wherein a further stabilization element (8) is attached to the third support (5) and the filament (3).

9. The emitter according to claim 8, wherein the further stabilization element (8) is attached to the filament (3) at a point on the opposite side of the emitter tip (4) with respect to the attachment point of the first stabilization element (6).

10. The emitter according to any of the preceding claims, wherein the filament (3) is a heating filament.

11. The emitter according to any of the preceding claims, wherein said third support (5) is a metallic support pin supported by an insulating base (1).

12. The emitter according to claim 11, wherein said third support (5) extends through the insulating base (1).

13. The emitter according to claim 11, wherein said third support (5) attached to a surface of the insulating base (1).

14. The emitter according to any of the preceding claims, further comprising a further stabilization element (8) attached to a fourth support (7) and to the filament (3), wherein the first, second and fourth supports (2, 7) define a triangle so that the further stabilization element (8) extends at least partially in a direction perpendicular to the direction in which the filament (3) extends.

15. The emitter according to claim 14, wherein the further stabilization element (8) is attached to the filament (3) at a point on the opposite side of the emitter tip (4) with respect to the attachment point of the first stabilization element (6).

16. The emitter according to claim 15, wherein the distance between the attachment point of the first stabilization element (6) and the emitter tip (4) is substantially equal to the distance between the attachment point of the further stabilization element (8) and the emitter tip (4).

17. The emitter according to any of claims 14 to 16, wherein said third and fourth supports (5, 7) are located on opposite sides of the filament (3).

18. The emitter according to any of the preceding claims, wherein said emitter is a Schottky emitter.

19. A method for stabilizing a charged particle emitter, comprising the steps of

(a) determining a first voltage between a first support of an emitter filament and a point where a stabilizing element is attached to the filament,
(b) determining a second voltage between a second support of the filament and a point where the stabilizing element is attached to the filament,
(c) determining a current through the filament,
(d) determining the temperature of an emitter tip from the first and second voltages and the current, and
(e) controlling a current source connected to the first and second supports so that the temperature of said emitter tip is maintained within a predetermined range.

20. The method according to claim 19, wherein in step (d) the temperature is determined from a temperature-dependent resistance of said filament.

21. The method according to claim 19, wherein in step (d) the temperature is determined from a power supplied to said filament.

22. A method for stabilizing a charged particle emitter, comprising the steps of

> (a) measuring a voltage between a first point where a first stabilizing element is attached to an emitter filament, and a second point where a further stabilizing element is attached to the filament,
> (b) determining a current through the filament,
> (c) determining the temperature of an emitter tip from the voltage and the current, and
> (d) controlling a current source connected to first and second supports of the filament so that the temperature of said emitter tip is maintained within a predetermined range.

23. The method according to claim 22, wherein in step (c) the temperature is determined from a temperature-dependent resistance of said filament.

24. The method according to claim 22, wherein in step (c) the temperature is determined from a power supplied to said filament.

Fig. 1a

Fig. 1b

Fig. 1c

Fig. 2a

Fig. 2b

Fig. 2c

Fig. 3a

Fig. 3b

Fig. 3c

Fig. 4a

Fig. 4b

Fig. 4c

Fig. 4d

Fig. 5a

Fig. 5b

Fig. 6a

Fig. 6b

Fig. 7a

Fig. 7b

PRIOR ART

Fig. 8a

PRIOR ART

Fig. 8b

PRIOR ART

Fig. 8c

PRIOR ART

Fig. 8d

PRIOR ART

Fig. 8e

**European Patent Office**

# EUROPEAN SEARCH REPORT

Application Number

EP 05 00 6277

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 393 651 A (ULRICH WOLFGANG DOERING) 12 June 1933 (1933-06-12) * page 2, lines 83-116; figures 5,7,10,11 * | 1-5,7-17 | H01J19/12 H01J37/07 H01J37/24 H01J1/13 H01J1/16 H01J3/02 |
| X | PATENT ABSTRACTS OF JAPAN vol. 004, no. 162 (E-033), 12 November 1980 (1980-11-12) -& JP 55 109343 A (CHIYOU LSI GIJUTSU KENKYU KUMIAI), 22 August 1980 (1980-08-22) * abstract; figures 4,5 * | 1-4,6, 11-16 | |
| X | US 4 068 145 A (NAKAGAWA ET AL) 10 January 1978 (1978-01-10) * column 2, lines 23-68; figure 2 * | 1,6, 14-17 | |
| X | FR 2 672 156 A (BABICH OLGERD; DEMCHENKO NIKOLAI; OSAULENKO NIKOLAI; SHUTOVSKY VLADISL) 31 July 1992 (1992-07-31) * page 8, line 18 - page 10, line 14; figures 3-5 * | 1-4, 7-10, 14-17 | |
| X | EP 0 641 007 A (SAMSUNG DISPLAY DEVICES CO., LTD; SAMSUNG DISPLAY DEVICES CO LTD) 1 March 1995 (1995-03-01) * column 3, line 41 - column 6, line 51; figures 4-16 * | 1,2,4,5, 7-11, 14-17 | TECHNICAL FIELDS SEARCHED (IPC) H01J |
| X | EP 0 207 772 A (BRUNGER, WILHELM HEINRICH DR; NIXON, WILLIAM CHARLES DR) 7 January 1987 (1987-01-07) * column 4, lines 18-35; figure 2 * | 1,2,4, 7-10, 14-16 | |
| X | DE 100 29 840 A1 (SCHLUMBERGER TECHNOLOGIES INC., SAN JOSE) 4 January 2001 (2001-01-04) * column 4, lines 21-30; figures 1,2 * | 1,4, 7-10,18 | |

-/--

The present search report has been drawn up for all claims

| Place of search | Date of completion of the search | Examiner |
|---|---|---|
| Munich | 23 December 2005 | Krauss, J |

EPO FORM 1503 03.82 (P04C01)

# EP 1 705 684 A1

## EUROPEAN SEARCH REPORT

Application Number

EP 05 00 6277

**European Patent Office**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 123 558 A (FEI COMPANY) 16 August 2001 (2001-08-16) * column 5, paragraph 21; figure 3 * ----- | 1,4,7, 10,11, 13,18 | |
| X | PATENT ABSTRACTS OF JAPAN vol. 013, no. 186 (E-752), 2 May 1989 (1989-05-02) & JP 01 012450 A (JEOL LTD), 17 January 1989 (1989-01-17) * abstract * ----- | 22,23 | |
| X | EP 0 075 708 A (SIEMENS AKTIENGESELLSCHAFT) 6 April 1983 (1983-04-06) * page 4, lines 9-31 * ----- | 22,24 | |
| A | EDINGER K ET AL: "Novel high resolution scanning thermal probe" JOURNAL OF VACUUM SCIENCE AND TECHNOLOGY. B, MICROELECTRONICS AND NANOMETER STRUCTURES PROCESSING, MEASUREMENT AND PHENOMENA, AMERICAN INSTITUTE OF PHYSICS, NEW YORK, NY, US, vol. 19, no. 6, November 2001 (2001-11), pages 2856-2860, XP012009144 ISSN: 1071-1023 * figure 1c * ----- | | TECHNICAL FIELDS SEARCHED (IPC) |

The present search report has been drawn up for all claims

| Place of search | Date of completion of the search | Examiner |
|---|---|---|
| Munich | 23 December 2005 | Krauss, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

18

**EP 1 705 684 A1**

## ANNEX TO THE EUROPEAN SEARCH REPORT
## ON EUROPEAN PATENT APPLICATION NO.

EP 05 00 6277

23-12-2005

| Patent document cited in search report | | Publication date | Patent family member(s) | | Publication date |
|---|---|---|---|---|---|
| GB 393651 | A | 12-06-1933 | NONE | | |
| JP 55109343 | A | 22-08-1980 | NONE | | |
| US 4068145 | A | 10-01-1978 | DE | 2658316 A1 | 07-07-1977 |
| | | | FR | 2336787 A1 | 22-07-1977 |
| | | | GB | 1572249 A | 30-07-1980 |
| | | | JP | 52077661 A | 30-06-1977 |
| | | | JP | 56036530 B | 25-08-1981 |
| | | | NL | 7614122 A | 28-06-1977 |
| FR 2672156 | A | 31-07-1992 | CA | 2034919 A1 | 26-07-1992 |
| | | | CN | 1064564 A | 16-09-1992 |
| | | | WO | 9103831 A1 | 21-03-1991 |
| EP 0641007 | A | 01-03-1995 | CN | 1099903 A | 08-03-1995 |
| | | | JP | 7085775 A | 31-03-1995 |
| EP 0207772 | A | 07-01-1987 | GB | 2178229 A | 04-02-1987 |
| | | | JP | 62085900 A | 20-04-1987 |
| DE 10029840 | A1 | 04-01-2001 | FR | 2795861 A1 | 05-01-2001 |
| | | | JP | 2001052596 A | 23-02-2001 |
| EP 1123558 | A | 16-08-2001 | DE | 60007830 D1 | 26-02-2004 |
| | | | DE | 60007830 T2 | 02-12-2004 |
| | | | WO | 0115192 A1 | 01-03-2001 |
| | | | JP | 2003507872 T | 25-02-2003 |
| JP 01012450 | A | 17-01-1989 | NONE | | |
| EP 0075708 | A | 06-04-1983 | DE | 3138900 A1 | 14-04-1983 |
| | | | JP | 58068831 A | 23-04-1983 |